# EUROPEAN PATENT APPLICATION

(11) **EP 2 669 828 A1**
(43) Date of publication of application: **04.12.2013**
(21) Application number: 13157991.4
(22) Date of filing: 06.03.2013
(51) Int. Cl.: G06F 17/50

(54) **Systems and methods of creating computerized model for a deep draw manufacturing simulation of a sheet metal part**

(30) Priority: 01.06.2012 US 201213485994
(71) Applicant: Livermore Software Technology Corporation, Livermore CA 94551 (US)
(72) Inventor: Zhu, Xinhai, Livermore, CA California 94551 (US); Yan, Quanqing, Livermore, CA California 94551 (US)
(74) Representative: Becker Kurig Straus

(57) **Abstract**

Systems and methods of creating a computerized model for a deep draw manufacturing simulation of a sheet metal part are disclosed. A series of computer generated visual diagrams are sequentially displayed upon receipt of a request from the user. The request is for creating a computerized model for a specific type of deep draw manufacturing simulation. The computerized model includes certain number of components for each particular type of simulations. The diagrams are configured for attracting the user's attention as to which component is being processed. Each diagram includes icons displayed in three different indicative schemes. The first indicative scheme shows components that have not been processed. The second indicative scheme shows a currently-processed component, while the third indicative scheme shows previously-processed components. The order of the series of diagrams is predetermined for each particular type of simulation hence minimizing human error in creation of the computerized model.

## Description

### FIELD OF THE INVENTION

The present invention generally relates to creation of a computerized model for mechanical computer aided engineering (CAE) analysis, more particularly to systems and methods of creating a computerized model for a deep draw manufacturing simulation of a sheet metal part.

### BACKGROUND OF THE INVENTION

Sheet metal forming has been used in the industry for years for creating metal parts from a blank sheet metal, for example, automobile manufacturers and their suppliers produce many parts using sheet metal forming. One of the most used sheet metal forming processes is deep drawing, which involves a hydraulic or mechanical press pushing a specially-shaped punch into a matching die with a piece of blank sheet metal in between. Exemplary products made from this process include, but are not limited to, car hood, fender, door, automotive fuel tank, kitchen sink, aluminum can, etc. In some areas of the die, the depth of a part or product being made is generally more than half its diameter. As a result, the blank is stretched and therefore thinned in various locations due to the geometry of the part or product. The part or product is only good when there is no structural defect such as material failure (e.g., cracking, tearing, wrinkling, necking, etc.).

In order to successfully manufacture a sheet metal part, many of the today's manufactures uses computer or numerical simulations (e.g., Computer Aided Engineering Analysis (CAE)). One useful computer simulation is based on finite element analysis (FEA), which is a computerized method widely used in industry to model and solve engineering problems relating to complex systems. FEA derives its name from the manner in which the geometry of the object under consideration is specified. With the advent of the modem digital computer, FEA has been implemented as FEA software. FEA software can be classified into two general types, implicit FEA software and explicit FEA software. Implicit FEA software uses an implicit equation solver to solve a system of coupled linear equations. Such software is generally used to simulate static or quasi-static problems. Explicit FEA software does not solve coupled equations but explicitly solves for each unknown assuming them uncoupled. Explicit FEA software usually uses central difference time integration which requires very small solution cycles or time steps for the method to be stable and accurate. Explicit FEA software is generally used to simulate short duration events where dynamics are important such as impact type events.

In simulating of deep draw manufacturing of a sheet metal part, a number of FEA models must be defined and assigned in a computer system for an application module to perform the simulation. Prior art approaches have been generally depending upon knowledge of the user. It would therefore desirable to have improved systems and methods of creating computerized model for a deep draw manufacturing simulation of a sheet metal part.

### BRIEF SUMMARY OF THE INVENTION

Systems and methods of creating a computerized model for a deep draw manufacturing simulation of a sheet metal part are disclosed. According to one aspect of the invention, a series of computer generated visual diagrams are sequentially displayed upon receipt of a request from the user. The request is for creating a computerized model for a specific type of deep draw manufacturing simulation. The computerized model includes certain number of components for each particular type of simulations. The diagrams are configured for attracting the user's attention as to which component is being processed. Each diagram includes icons displayed in three different indicative schemes. The first indicative scheme shows components that have not been processed. The second indicative scheme shows a currently-processed component, while the third indicative scheme shows previously-processed components. The order of the series of diagrams is predetermined for each particular type of simulation hence minimizing human error in creation of the computerized model.

According to another aspect, the first indicative scheme is configured to show component in red color, the second in flashing yellow and the third in green.

Objects, features, and advantages of the present invention will become apparent upon examining the following detailed description of an embodiment thereof, taken in conjunction with the attached drawings.

### BRIEF DESCRIPTION OF THE DRAWINGS

These and other features, aspects, and advantages of the present invention will be better understood with regard to the following description, appended claims, and accompanying drawings as follows:

FIG. 1 is a diagram showing an elevation cross-section view of an exemplary set up of a draw die for deep draw manufacturing of a sheet metal part;

FIG. 2 is a diagram showing an exemplary series of related deep draw manufacturing simulations of sheet metal part;

FIG. 3 is a flowchart illustrating an exemplary process of creating a computerized model for deep draw manufacturing simulation of a sheet metal part, according to one embodiment of the present invention;

FIG. 4 shows an exemplary visual diagram in accordance with one embodiment of the present invention;

FIGS. 5A-5D show exemplary series of indicative schemes for displaying schematic icons in the visual diagram, according to an embodiment of the present invention; and

FIG. 6 is a functional block diagram showing salient components of an exemplary computer, in which one embodiment of the present invention may be implemented.

### DETAILED DESCRIPTION

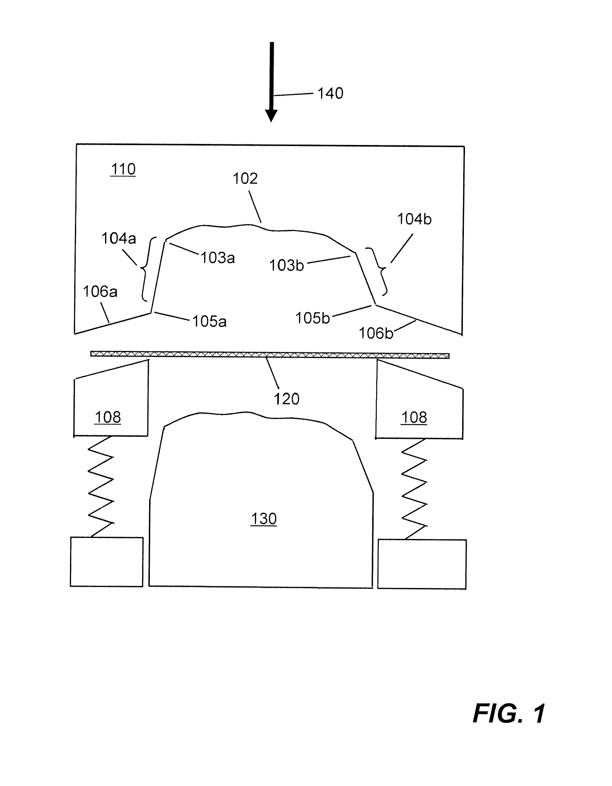

Referring first to FIG. 1, it is shown a sheet metal blank or blank 120 (i.e., an unformed sheet metal plate before being formed) is rest on a blank holder 108 between an upper die cavity 110 and a punch 130. The blank 110 is formed into a sheet metal part when the die 110 is pushed down to the punch 130 in the direction of the draw axis (shown by an arrow 140). The die 110 has a product design section 102, binder section 106a-b and addendum section 104a-b. The boundary between the addendum section 104a-b and the design surface section 102 is referred to as a trim line 103a-b, while the direct intersection between the addendum sections 104a-b and the binder section 106a-b is referred to as theoretical punch opening line 105a-b. Trim lines are mostly enclosed and there can be more than one enclosed trim lines in a sheet metal part. It is possible to have more than one hundred enclosed trim lines for forming a complex sheet metal part.

Product surface contains the desired pattern/shape of a sheet metal part at the end of the forming process followed by a trimming operation. Binder section is configured for holding the blank during the forming process. Addendum section provides a buffer or transition zone between the product design surface section and the binder section. After the blank is shaped by the punch, the sheet metal part is cut out along the enclosed trim lines. A well or properly defined trim line allows the manufacturer to convert a blank into its final configuration either directly or faster hence significantly reducing the manufacturing costs of a sheet metal part.

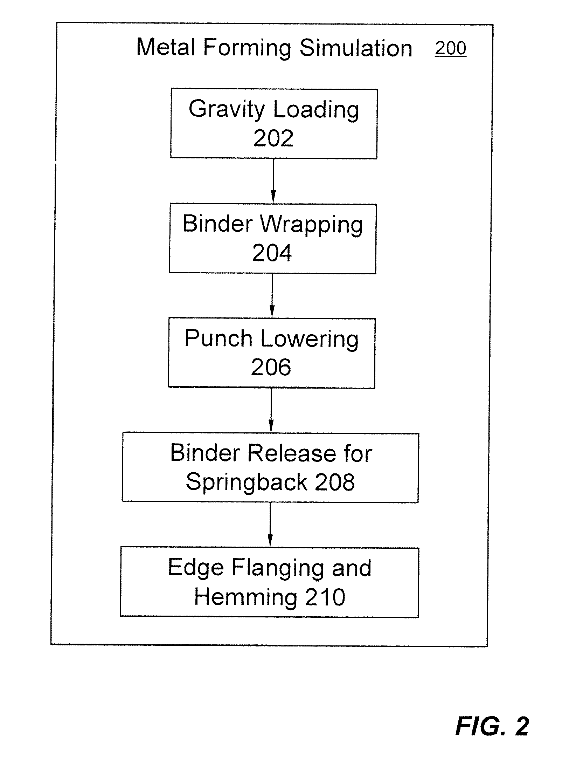

For simulating a deep drawing manufacturing of a sheet metal part, a number of different types of simulation are performed. FIG. 2 lists an exemplary series of such simulations. The exemplary series is a metal forming simulation 200 (e.g., forming an automobile part from sheet metal). Metal forming simulation 200 comprises a number of phases: 1) gravity loading 202, 2) binder wrapping 204, 3) puncn lowering 206, 4) binder release for springback 208 and 5) edge flanging and hamming 210.

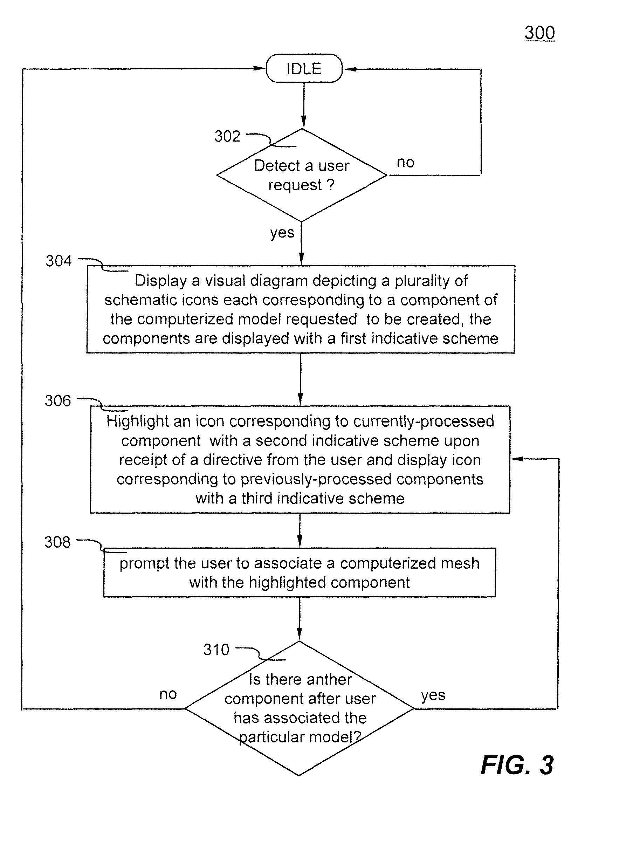

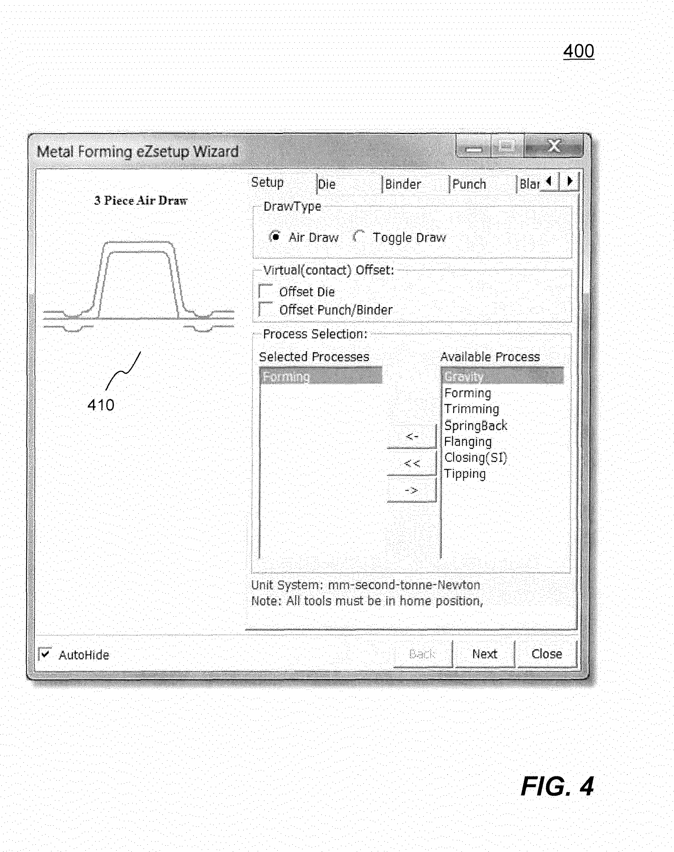

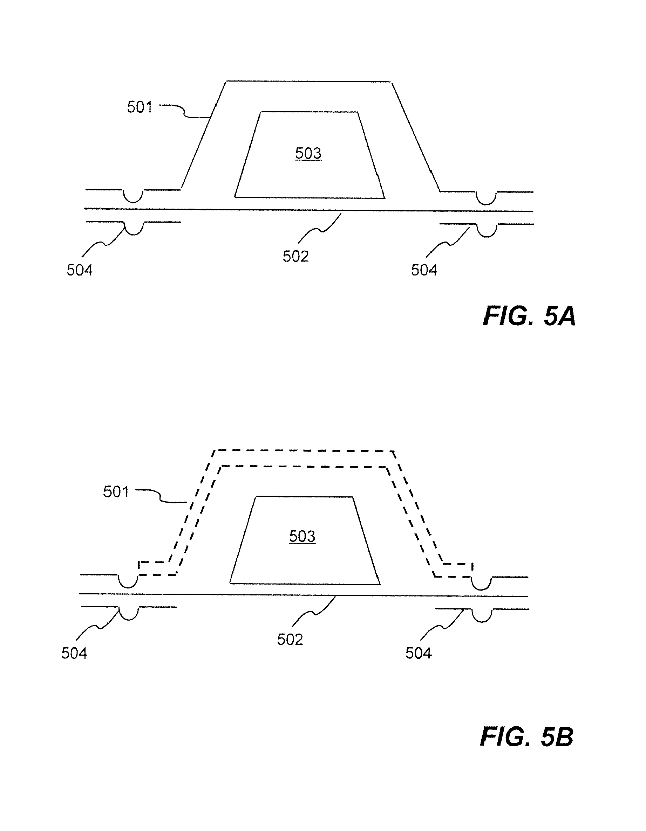

FIG. 3 is a flowchart illustrating an exemplary process 300 of creating computerized model for a deep draw manufacturing simulation of a sheet metal part. Process 300 is preferably implemented in software and understood in conjunction with other figures particularly FIGS. 4 and 5A-5D.

Process 300 starts in an "IDLE" state until a request from a user is detected at test 302. The request indicates that the user is desirous of creating a computerized model for a specific type of deep draw manufacturing simulation. Exemplary types of simulations can be found in FIG. 2.

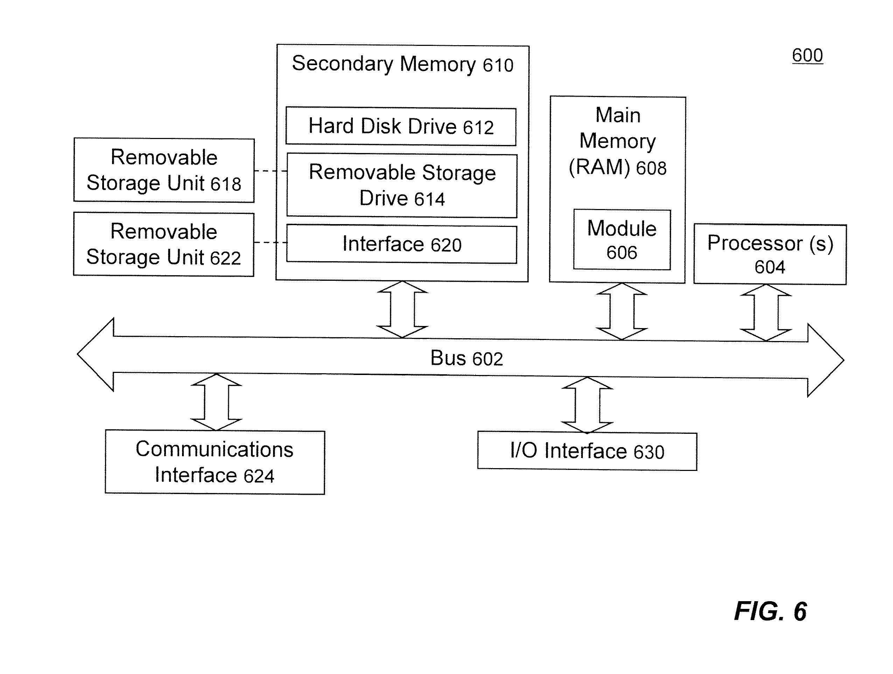

Upon detection of the user request at step 304, process 300 displays a visual diagram on a computer monitor operatively adapted to a computer system (e.g., computer system 600 of FIG. 6) on which a computerized model creation application module is installed. Exemplary visual diagram includes, but is not limited to, a popup window, an area of the computer monitor allowing user interaction with the computerized model creation application module. FIG. 4 shows an exemplary visual diagram 400, which depicts a plurality of icons 410 (see below for more details in FIGS. 5A-5D) each corresponding to one of the components of the computerized model of the specific type of simulation. In addition, the icons are displayed in a first indicative scheme initially or not having processed.

After the initial setup has been completed, process 300 starts processes the creation of the computerized model. In particular, components of a computerized model are processed (e.g., defined by the user) in a predetermined order (e.g., an order programmed in the computerized model creation application module). At step 306, upon a directive from the user, process 300 highlights the icon corresponding to a currently-processed component with a second indicative scheme. Process 300 also displays icons corresponding to previously processed components with a third indicative scheme. The second indicative scheme is configured to attract user the user's attention for the currently-processed component, while the third indicative scheme is for those components have been processed.

At step 308, process 300 prompts the user to associate a computerized mesh (e.g., a finite element analysis mesh) to the highlighted or currently-processed component. Next, at test 310, it is determined whether another component of the computerized model needs to be processed. If "yes", process 300 moves back to repeat steps 306-308 until there is no more component to be processed. Then, process 300 moves back to the "IDLE" state waiting for another user request.

To demonstrate three different indicative schemes for displaying icons in a visual diagram, an exemplary series of a deep draw manufacturing simulation model creation is shown in FIGS. 5A-5D. FIG. 5A shows a first icon 501 corresponding to a die, second icon 502 to a sheet metal blank, third icon 503 to a punch and fourth icon 504 to drawbeads. In this example, the predetermined order of model creation is as follows: a) die, b) blank, 3) punch and 4) drawbeads. Initially all icons 501-504 are displayed in a first indicative scheme (thinner solid lines) since none of the components has been processed (i.e., defined by the user or associated with a computerized mesh).

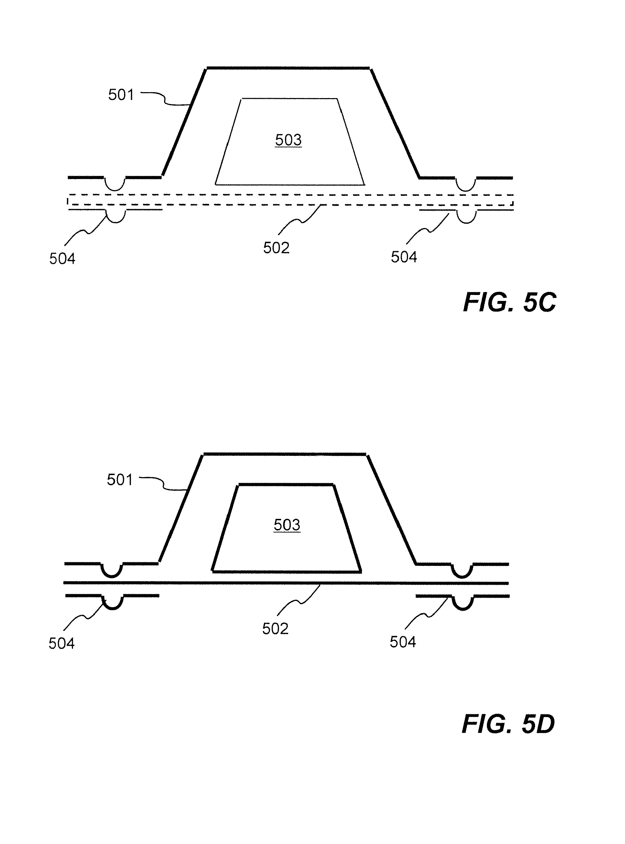

Next, when the first component, die, is being processed, the first icon 501 is highlighted with a second indicative scheme (dotted lines) in FIG. 5B. After the first component has been processed, shown in FIG. 5C, the second component, sheet metal blank, is highlighted with the second indicative scheme, while the previously processed components (the first component in this situation) is displayed with a third indicative scheme (thicker solid line) for indicating components have been processed or defined. The series of visual diagrams continues with next component (no0t shown) until all components have been processed or defined. FIG. 5D shows all icons 501-504 have been defined hence being displayed with the third indicative scheme.

According to one embodiment, first, second and third indicative schemes can be configured with three different colors on a color computer monitor. According to another embodiment, the second indicative scheme is configured with a flashing display to emphasize the currently-processed component. For those of ordinary skill in the art would appreciate many different well-known schemes to represent three indicative schemes.

According to one aspect, the present invention is directed towards one or more computer systems capable of carrying out the functionality described herein. An example of a computer system 600 is shown in FIG. 6. The computer system 600 includes one or more processors, such as processor 604. The processor 604 is connected to a computer system internal communication bus 602. Various software embodiments are described in terms of this exemplary computer system. After reading this description, it will become apparent to a person skilled in the relevant art(s) how to implement the invention using other computer systems and/or computer architectures.

Computer system 600 also includes a main memory 608, preferably random access memory (RAM), and may also include a secondary memory 610. The secondary memory 610 may include, for example, one or more hard disk drives 612 and/or one or more removable storage drives 614, representing a floppy disk drive, a magnetic tape drive, an optical disk drive, etc. The removable storage drive 614 reads from and/or writes to a removable storage unit 618 in a well-known manner. Removable storage unit 618, represents a floppy disk, magnetic tape, optical disk, etc. which is read by and written to by removable storage drive 614. As will be appreciated, the removable storage unit 618 includes a computer usable storage medium having stored therein computer software and/or data.

In alternative embodiments, secondary memory 610 may include other similar means for allowing computer programs or other instructions to be loaded into computer system 600. Such means may include, for example, a removable storage unit 622 and an interface 620. Examples of such may include a program cartridge and cartridge interface (such as that found in video game devices), a removable memory chip (such as an Erasable Programmable Read-Only Memory (EPROM), Universal Serial Bus (USB) flash memory, or PROM) and associated socket, and other removable storage units 622 and interfaces 620 which allow software and data to be transferred from the removable storage unit 622 to computer system 600. In general, Computer system 600 is controlled and coordinated by operating system (OS) software, which performs tasks such as process scheduling, memory management, networking and I/O services.

There may also be a communications interface 624 connecting to the bus 602. Communications interface 624 allows software and data to be transferred between computer system 600 and external devices. Examples of communications interface 624 may include a modem, a network interface (such as an Ethernet card), a communications port, a Personal Computer Memory Card International Association (PCMCIA) slot and card, etc. Software and data transferred via communications interface 624 are in the form of signals 628 which may be electronic, electromagnetic, optical, or other signals capable of being received by communications interface 624. The computer 600 communicates with other computing devices over a data network based on a special set of rules (i.e., a protocol). One of the common protocols is TCP/IP (Transmission Control Protocol/Internet Protocol) commonly used in the Internet. In general, the communication interface 624 manages the assembling of a data file into smaller packets that are transmitted over the data network or reassembles received packets into the original data file. In addition, the communication interface 624 handles the address part of each packet so that it gets to the right destination or intercepts packets destined for the computer 600.In this document, the terms "computer program medium" and "computer usable medium" are used to generally refer to media such as removable storage drive 614, and/or a hard disk installed in hard disk drive 612. These computer program products are means for providing software to computer system 600. The invention is directed to such computer program products.

The computer system 600 may also include an input/output (I/O) interface 630, which provides the computer system 600 to access monitor, keyboard, mouse, printer, scanner, plotter, and alike.

Computer programs (also called computer control logic) are stored as application modules 606 in main memory 608 and/or secondary memory 610. Computer programs may also be received via communications interface 624. Such computer programs, when executed, enable the computer system 600 to perform the features of the present invention as discussed herein. In particular, the computer programs, when executed, enable the processor 604 to perform features of the present invention. Accordingly, such computer programs represent controllers of the computer system 600.

In an embodiment where the invention is implemented using software, the software may be stored in a computer program product and loaded into computer system 600 using removable storage drive 614, hard drive 612, or communications interface 624. The application module 606, when executed by the processor 604, causes the processor 604 to perform the functions of the invention as described herein.

The main memory 608 may be loaded with one or more application modules 606 that can be executed by one or more processors 604 with or without a user input through the I/O interface 630 to achieve desired tasks. In operation, when at least one processor 604 executes one of the application modules 606, the results are computed and stored in the secondary memory 610 (i.e., hard disk drive 612). The status of the computerized model creation is (e.g., finite element analysis model) is reported to the user via the I/O interface 630 either in a text or in a graphical representation.

Although the present invention has been described with reference to specific embodiments thereof, these embodiments are merely illustrative, and not restrictive of, the present invention. Various modifications or changes to the specifically disclosed exemplary embodiments will be suggested to persons skilled in the art. For example, whereas one particular type of deep draw manufacturing simulation (3-piece air draw) has been described and shown, other types may be used, for example, toggle draw, trimming, etc. In summary, the scope of the invention should not be restricted to the specific exemplary embodiments disclosed herein, and all modifications that are readily suggested to those of ordinary skill in the art should be included within the spirit and purview of this application and scope of the appended claims.

## Claims

1. A method of creating a computerized model for a deep draw manufacturing simulation of a sheet metal part, said method comprising:
(a) receiving, from a user, a request of creating a computerized model for a particular type of deep draw manufacturing simulation in a computer system having a computerized model creation application module installed thereon, the computerized model containing a plurality of components required in said particular type of deep draw manufacturing simulation and the components are created in a predetermined order;
(b) displaying a visual diagram, on a computer monitor operatively adapted to the computer system, depicting a plurality of icons with each icon corresponding to one of the components, the icons being shown in a first indicative scheme;
(c) highlighting the icon corresponding to currently-processed component of the components in the visual diagram with a second indicative scheme upon receipt of a directive from the user and the displaying previously highlighted icons with a third indicative scheme;
(d) prompting the user to associate a computerized mesh to the currently-processed component; and
(e) repeating steps (c)-(d) until said all of the components in the predetermined order have been processed or associated with the respective computerized meshes, said computerized model is created as a result.

2. The method of claim 1, wherein the computerized model is a finite element analysis model.

3. The method of claim 1, wherein the visual diagram is configured for assisting the user in creating the computerized model.

4. The method of claim 3, wherein the visual diagram is a pop-up window.

5. The method of claim 3, wherein the visual diagram is an area of the computer monitor allowing an interactive session between user and the computerized model creation application module.

6. The method of claim 1, wherein the first indicative scheme is configured for showing icons corresponding to components that have not been processed.

7. The method of claim 1, wherein the second indicative scheme is configured for attracting the user's attention for working on the currently-processed component.

8. The method of claim 1, wherein the third indicative scheme is configured for showing icons corresponding to components have been processed.

9. The method of claim 1, wherein said particular type of deep draw manufacturing simulation comprises gravity loading, binder wrapping, punch lowering, springback or edge flanging.

10. The method of claim 1, wherein said plurality of components comprises a die, a sheet metal blank, a punch and drawbeads.

11. A system for creating a computerized model for a deep draw manufacturing simulation of a sheet metal part, said system comprising:
an input/output (I/O) interface;
a memory for storing computer readable code for a computerized model creation application module; and
at least one processor coupled to the memory, said at least one processor executing the computer readable code in the memory to cause the computerized model creation application module to perform operations of:
(a) receiving, from a user, a request of creating a computerized model for a particular type of deep draw manufacturing simulation, the computerized model containing a plurality of components required in said particular type of deep draw manufacturing simulation and the components are created in a predetermined order;
(b) displaying a visual diagram, on a computer monitor operatively adapted to the system, depicting a plurality of icons with each icon corresponding to one of the components, the icons being shown in a first indicative scheme;
(c) highlighting the icon corresponding to currently-processed component of the components in the visual diagram with a second indicative scheme upon receipt of a directive from the user and displaying the previously highlighted icons with a third indicative scheme;
(d) prompting the user to associate a computerized mesh to the currently-processed component; and
(e) repeating steps (c)-(d) until said all of the components in the predetermined order have been processed or associated with the respective computerized meshes, said computerized model is created as a result.

12. A non-transitory computer readable storage medium containing instructions for creating a computerized model for a deep draw manufacturing simulation of a sheet metal part by a method comprising:
(a) receiving, from a user, a request of creating a computerized model for a particular type of deep draw manufacturing simulation in a computer system having a computerized model creation application module installed thereon, the computerized model containing a plurality of components required in said particular type of deep draw manufacturing simulation and the components are created in a predetermined order;
(b) displaying a visual diagram, on a computer monitor operatively adapted to the computer system, depicting a plurality of icons with each icon corresponding to one of the components, the icons being shown in a first indicative scheme;
(c) highlighting the icon corresponding to currently-processed component of the components in the visual diagram with a second indicative scheme upon receipt of a directive from the user and displaying the previously highlighted icons with a third indicative scheme;
(d) prompting the user to associate a computerized mesh to the currently-processed component; and
(e) repeating steps (c)-(d) until said all of the components in the predetermined order have been processed or associated with the respective computerized meshes, said computerized model is created as a result.
